Europäisches Patentamt

European Patent Office

Office européen des brevets

(11) Veröffentlichungsnummer: **0 455 156 A2**

## (12) EUROPÄISCHE PATENTANMELDUNG

(21) Anmeldenummer: **91106778.3**

(22) Anmeldetag: **26.04.91**

(51) Int. Cl.5: **H03H 11/18**

(30) Priorität: **04.05.90 AT 1010/90**

(43) Veröffentlichungstag der Anmeldung:
**06.11.91 Patentblatt 91/45**

(84) Benannte Vertragsstaaten:
**AT DE FR IT**

(71) Anmelder: **Siemens Aktiengesellschaft Österreich**
**Siemensstrasse 88 - 92**
**A-1210 Wien(AT)**

(84) **AT**

Anmelder: **Siemens Aktiengesellschaft**
**Postfach 22 16 34**
**W-8000 München 2(DE)**

(84) **DE FR IT**

(72) Erfinder: **Kreuzgruber, Peter, Dipl.-Ing.**
**Albertg. 11/8**
**A-1080 Wien(AT)**
Erfinder: **Österreicher, Johannes, Dipl.-Ing.**
**Elisabethstrasse 81**
**A-2500 Baden(AT)**

(54) **Schaltungsanordnung zur Erzeugung eines analogen, um 90 Grad gegenüber einem Eingangssignal phasenverschobenen Ausgangssignals.**

(57) Ein Eingang (E) eines analogen 90° Phasenschiebers ist mit einem ersten Detektoreingang (A) eines Phasendetektors (1) verbunden. Der Ausgang des Phasendetektors (1) ist über ein Tiefpaßfilter (3) und ein Phasendrehglied (2) mit einem zweiten Detektoreingang (B) rückgekoppelt. Diese Schaltungsteile bilden einen Regelkreis, dessen stabiler Punkt erreicht ist, wenn die Phasenverschiebung der beiden Signale an den Detektoreingängen (A,B) 90° beträgt. Eine eventuell auftretende Abhängigkeit der Signalamplitude am Ausgang des Phasenschiebers wird durch einen regelbaren Verstärker (4) kompensiert. Das Eingangssignal wird phasenrichtig an den Ausgang (I) übertragen, das 90°-Ausgangssignal liegt an einem Quadraturausgang (Q) an.

FIG 1

EP 0 455 156 A2

Die Erfindung betrifft eine Schaltungsanordnung zur Erzeugung eines analogen, um 90° gegenüber einem Eingangssignal phasenverschobenen Ausgangssignals, wobei ein Eingang eines Phasendrehgliedes mit einem Eingang der Schaltungsanordnung verbunden und das 90°-Ausgangssignal des Phasendrehgliedes einem Quadraturausgang der Schaltungsanordnung zugeleitet ist.

Eine derartige Schaltungsanordnung ist aus der DE-OS 36 24 854 bekannt. Das Eingangssignal wird über ein phasendrehendes Netzwerk an einen steuerbaren Verstärker geleitet. Der Betrag und das Vorzeichen des Ausgangssignals ist veränderbar. In einem Parallelzweig wird das Eingangssignal lediglich konstant verstärkt dem Ausgang zugeführt. Die Schaltung wird für Farbtonregler von Farbfernsehgeräten verwendet.

Für die Erzeugung von analogen Signalen in Quadraturlage werden im allgemeinen analoge Phasendrehglieder und Brückenschaltungen, sowie Leistungsteilerhybride verwendet. Bei diesen Schaltungsanordnungen hängt entweder die Phasendrehung von der Eingangsfrequenz ab, oder sie sind nur in einem schmalen Frequenzband einsetzbar. Die Realisierung eines 90°-Phasenschiebers mit Hilfe einer PLL-Schaltungsanordnung erfordert einen zusätzlichen Oszillator, der insbesondere im Frequenzbereich des UHF- und Mikrowellenbandes einen beträchtlichen Schaltungsaufwand erfordert. Zu dem sind PLL-Schaltungsanordnungen einschließlich ihres Oszillators bisher nicht integrierbar. Für Frequenzen bis zu einigen 10 MHz können Signale in Quadraturlage digital, durch Verwendung einer ROM-Filtertabelle realisiert werden. Die Frequenzgrenze ist bei diesem Verfahren durch die maximale Arbeitsfrequenz der verfügbaren Digitalschaltungen festgelegt.

Der Erfindung liegt die Aufgabe zugrunde, aus einem breitbandig modulierten Signal ein Signal in Quadraturlage zu erzeugen.

Dies wird erfindungsgemäß dadurch gelöst, daß der Eingang mit einem ersten Detektoreingang eines Phasendetektors verbunden ist, dessen Ausgang über eine Mittelwertschaltung und das Phasendrehglied an einen zweiten Detektoreingang rückgekoppelt ist.

Diese Schaltungsanordnung kann eingesetzt werden, um aus dem Signal des Lokaloszillators eines Homodynempfängers ein in Quadraturlage befindliches Signal zu erzeugen. Sie hat den Vorteil, integrierbar zu sein und ist daher für Mobiltelefone besonders geeignet. Die Schaltungsanordnung kann je nach Aufbau für die Erzeugung von Quadratursignalen bis in den Mikrowellenbereich und für Modulationsbandbreiten von einigen MHz eingesetzt werden.

Es ist vorteilhaft, daß die Mittelwertschaltung ein Tiefpaßfilter ist. Insbesondere besteht das Tiefpaßfilter aus einem invertierenden Verstärker und einem RC-Glied.

Zum Aufbau eines Amplitudenregelmechanismus ist es vorteilhaft, daß ein regelbarer Verstärker dem Ausgang des Phasendrehgliedes nachgeschaltet ist und daß der Regeleingang des Verstärkers über einen ersten Pegeldetektor mit dem Quadraturausgang und über einen zweiten Pegeldetektor mit dem Eingang verbunden ist. Somit kann Pegelgleichheit zwischen dem Oszillatorsignal und dem erzeugten Quadratursignal sichergestellt werden. Zur günstigen Realisierung ist das Phasendrehglied eine Schaltungsanordnung mit spannungssteuerbarer Phasendrehung. Dabei ist das Phasendrehglied als Allpaßfilter oder RC-Tiefpaßfilter mit abstimmbaren Widerstand aufgebaut.

Zur besseren Integrierbarkeit ist es vorteilhaft, daß der Phasendetektor statt einem analogen Multiplizierer ein digitaler Phasendetektor ist.

Die Erfindung wird anhand von Ausführungsbeispielen und Zeichnungen näher erläutert. Es zeigen:

Fig. 1 das Blockschaltbild des ersten Ausführungsbeispieles und

Fig. 2 das Schaltbild des zweiten Ausführungsbeispieles.

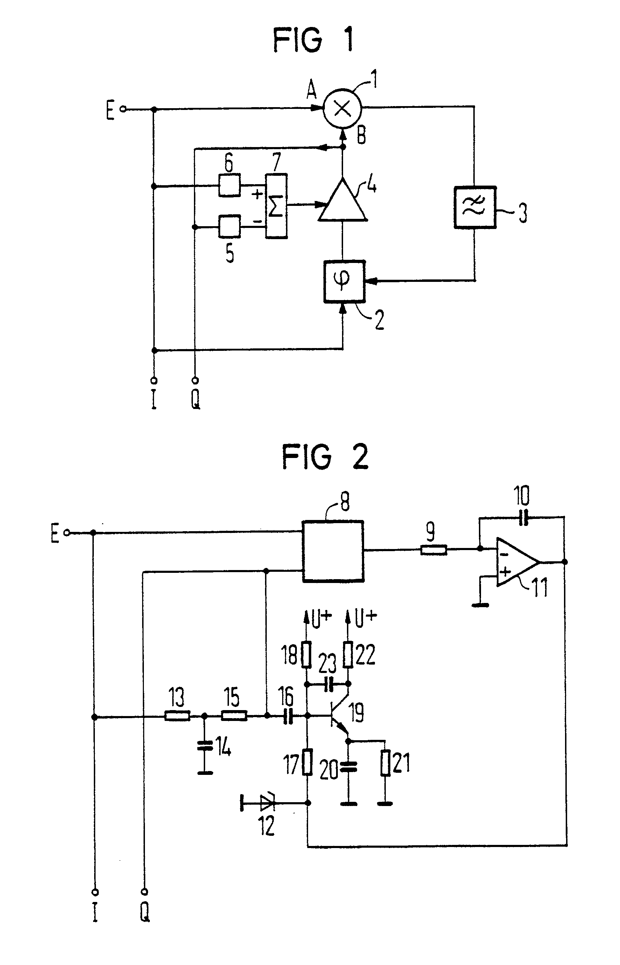

In Fig. 1 ist ein analoger, integrierbarer 90°-Phasenschieber dargestellt. Ein Eingangssignal am Eingang E wird phasenrichtig an einen Ausgang I übertragen. Die Erzeugung eines Quadratursignals erfolgt durch einen spannungssteuerbaren Phasenschieber, der durch einen Regelkreis auf 90° Phasendrehung abgestimmt wird. Das 90°-Ausgangssignal wird einem Quadraturausgang Q zugeleitet.

Der Eingang E der Schaltungsanordnung ist mit einem ersten Detektoreingang A eines Phasendetektors 1 verbunden. Liegen am ersten Detektoreingang A und einem zweiten Detektoreingang B zwei harmonische Signale mit einer Phasenverschiebung von 90° zueinander an, so ist die Signalspannung am Ausgang des Phasendetektors 1 mittelwertfrei. Ist die Phasenverschiebung des Signals am zweiten Detektoreingang B zu jener am ersten Detektoreingang A kleiner als 90°, so wird der Mittelwert am Ausgang des Phasendetektors 1 positiv. Bei einer Phasenverschiebung der beiden Signale von mehr als 90°, ergibt sich ein negativer Mittelwert am Ausgang des Phasendetektors 1. Die Mittelwertbildung der Signalspannung des Phasendetektors 1 erfolgt durch ein dem Ausgang des Phasendetektors 1 nachgeschaltetes Tiefpaßfilter 3. Ein Phasendrehglied 2 ist mit dem Tiefpaßfilter 3 und dem Phasendetektor 1 verbunden. Es vergrößert die Phasendrehung zwischen Ein- und Ausgang für positive Steuerspannung, bzw. verkleinert sie für negative Steuerspannung. Der Phasendetektor 1, das Tiefpaßfilter 3 und der Phasenschieber 2 bilden einen Regelkreis, dessen stabiler Punkt bei einer Phasenverschiebung der beiden Signale an den beiden Detektoreingängen A,B von 90° erreicht ist. Eine eventuell auftretende Abhängigkeit der Signalamplitude am Ausgang des Phasenschiebers wird dadurch kompensiert, daß ein regelbarer Verstärker 4 (AGC-Verstärker) in den Regelkreis geschaltet ist. Die Regelspannung für diesen Verstärker 4 wird durch zwei Pegeldetektoren 5,6 erzeugt, die die Signalleistungen am Ausgang I und am Quadraturausgang Q messen. Die Signalleistungen werden in einem Summierglied 7 subtrahiert, das zwischen die Pegeldetektoren 5,6 und den regelbaren Verstärker 4 geschaltet ist.

Eine Auswahl der Schaltungsteile erfolgt in Abhängigkeit vom Betriebsfrequenzbereich. Die maximale Modulationsbandbreite bei modulierten Eingangssignalen wird durch die Grenzfrequenz des Tiefpaßfilters 3 und die Bandbreite des Amplitudenregelkreises, insbesondere der Bandbreite des Summiergliedes 7 bestimmt. Als Pegeldetektoren 5,6 können Spitzenwertgleichrichter mit nachfolgender Tiefpaßfilterung eingesetzt werden.

Das zweite Ausführungsbeispiel gemäß Fig. 2 ist gegenüber dem ersten Ausführungsbeispiel etwas abgewandelt, bzw. genauer gezeigt. Es ist ein digitaler Phasendetektor 8 mit dem Eingang E verbunden. Das Tiefpaßfilter besteht aus einem invertierenden Verstärker 11 und einem RC-Glied 9,10, durch das die Grenzfrequenz des Tiefpaßfilters festgelegt wird. Das spannungssteuerbare Phasendrehglied besteht aus einem zweistufigen RC-Glied, worin ein erster Widerstand 13 und ein erster Kondensator 14 die erste Stufe und ein zweiter Widerstand 15 und eine Reaktanzstufe die zweite Stufe des Phasendrehgliedes bilden. Die Reaktanzstufe besteht aus einem Bipolartransistor 19, der über eine Rückkopplungskapazität 23 rückgekoppelt ist. Für Frequenzen über einigen 100 MHz kann diese Rückkopplungskapazität 23 entfallen, da durch die Millerkapazität des Bipolartransistors 19 eine ausreichende Phasendrehung des Phasendrehgliedes erzielt werden kann. Mit einem Kollektorwiderstand 22 wird die Größe der Eingangskapazität dieser Reaktanzstufe festgelegt. Ein Stabilisierungswiderstand 21 dient der Stabilisierung des Arbeitspunktes, ein Stabilisierungskondensator 20 bewirkt eine Vergrößerung der effektiven Steilheit des Bipolartransistors 19. Der Wert der Eingangskapazität ist eine lineare Funktion der Steilheit und damit des Kollektorstroms des Bipolartransistors 19. Der Kollektorstrom wird durch einen Basisspannungsteiler 17,18 festgelegt. Die Spannungsabhängigkeit der Reaktanzstufe entsteht durch die Variation der Spannung des Basisspannungsteilers 17,18. Die Reaktanzstufe ist durch einen Koppelkondensator 16 vom Radiofrequenz-Signalpfad galvanisch getrennt. Eine Zenerdiode 12 begrenzt die maximal auftretende Spannung am Basisspannungsteiler 17,18. Auf den Schaltungsteil zur Pegelstabilisierung wurde in diesem Ausführungsbeispiel verzichtet.

## Patentansprüche

1. Schaltungsanordnung zur Erzeugung eines analogen, um 90° gegenüber einem Eingangssignal phasenverschobenen Ausgangssignals, wobei ein Eingang eines Phasendrehgliedes (2) mit einem Eingang (E) der Schaltungsanordnung verbunden und das 90°-Ausgangssignal des Phasendrehgliedes (2) einem Quadraturausgang (Q) der Schaltungsanordnung zugeleitet ist, **dadurch gekennzeichnet,** daß der Eingang (E) mit einem ersten Detektoreingang (A) eines Phasendetektors (1) verbunden ist, dessen Ausgang über eine Mittelwertschaltung und das Phasendrehglied (2) an einen zweiten Detektoreingang (B) rückgekoppelt ist.

2. Schaltungsanordnung nach Anspruch 1, **dadurch gekennzeichnet,** daß die Mittelwertschaltung ein Tiefpaßfilter (3) ist.

3. Schaltungsanordnung nach Anspruch 2, **dadurch gekennzeichnet,** daß das Tiefpaßfilter (3) aus einem invertierenden Verstärker (11) und einem RC-Glied (9,10) besteht.

4. Schaltungsanordnung nach einem der vorherigen Ansprüche, **dadurch gekennzeichnet,** daß ein regelbarer Verstärker (4) dem Ausgang des Phasendrehgliedes (2) nachgeschaltet ist und daß der Regeleingang des Verstärkers (4) über einen ersten Pegeldetektor (5) mit dem Quadraturausgang (Q) und über einen zweiten Pegeldetektor (6) mit dem Eingang (E) verbunden ist.

5. Schaltungsanordnung nach einem der vorherigen Ansprüche, **dadurch gekennzeichnet,** daß das Phasendrehglied (2) eine Schaltungsanordnung mit spannungssteuerbarer Phasendrehung ist.

6. Schaltungsanordnung nach Anspruch 5, **dadurch gekennzeichnet,** daß das Phasendrehglied (2) als Allpaßfilter oder RC-Tiefpaßfilter mit abstimmbarem Widerstand aufgebaut ist.

7. Schaltungsanordnung nach einem der vorherigen Ansprüche, **dadurch gekennzeichnet,** daß der Phasendetektor (1) ein digitaler Phasendetektor (8) ist.

# FIG 1

# FIG 2